(19) Europäisches Patentamt
European Patent Office
Office européen des brevets

(11) **EP 1 937 757 B1**

(12) **EUROPEAN PATENT SPECIFICATION**

(45) Date of publication and mention
of the grant of the patent:
**17.10.2018 Bulletin 2018/42**

(51) Int Cl.:
*C08J 7/12* *(2006.01)*          *B05D 3/14* *(2006.01)*
*H05H 1/14* *(2006.01)*          *B81B 1/00* *(2006.01)*

(21) Application number: **06710193.1**

(22) Date of filing: **08.03.2006**

(86) International application number:
**PCT/GR2006/000011**

(87) International publication number:
**WO 2007/031799 (22.03.2007 Gazette 2007/12)**

(54) **METHOD FOR THE FABRICATION OF HIGH SURFACE AREA RATIO AND HIGH ASPECT RATIO SURFACES ON SUBSTRATES**

VERFAHREN ZUR HERSTELLUNG VON OBERFLÄCHEN MIT HOHEM OBERFLÄCHENVERHÄLTNIS UND HOHEM ASPEKTVERHÄLTNIS AUF SUBSTRATEN

PROCÉDÉ DE FABRICATION DE SURFACES DE SUBSTRAT POSSÉDANT UN RAPPORT DE SURFACE ET UN RAPPORT LARGEUR-LONGUEUR ÉLEVÉS

(84) Designated Contracting States:
**AT BE BG CH CY CZ DE DK EE ES FI FR GB GR HU IE IS IT LI LT LU LV MC NL PL PT RO SE SI SK TR**

(30) Priority: **16.09.2005 GR 20050100473**

(43) Date of publication of application:
**02.07.2008 Bulletin 2008/27**

(73) Proprietors:
• **National Center for Scientific Research Demokritos**
  **15310 Athens (GR)**
• **Tserepi, Angeliki**
  **153 10 Agia Paraskevi Attikis (GR)**
• **Gogolidis, Evangelos**
  **153 10 Agia Paraskevi Attikis (GR)**
• **Misiakos, Konstantinos**
  **153-10 Agia Paraskevi Attikis (GR)**

(72) Inventors:
• **TSEREPI, Angeliki**
  **153 10 Agia Paraskevi Attikis (GR)**
• **GOGOLIDES, Evangelos**
  **153 10 Agia Paraskevi Attikis (GR)**
• **MISIAKOS, Konstantinos**
  **153 10 Agia Paraskevi Attikis (GR)**
• **VLACHOPOULOU, Maria-Elena**
  **153 10 Agia Paraskevi Attikis (GR)**
• **VOURDAS, Nikolaos**
  **153 10 Agia Paraskevi Attikis (GR)**

(74) Representative: **Malamis, Alkisti-Irene**
**Malamis & Associates**
**Attorneys at Law**
**8 Palaia Tatoiou Street**
**145 64 Kifissia, Athens (GR)**

(56) References cited:
• **VLACHOPOULOU M E ET AL: "Patterning of thick polymeric substrates for the fabrication of microfluidic devices" 1 January 2005 (2005-01-01), JOURNAL OF PHYSICS: CONFERENCE SERIES, INSTITUTE OF PHYSICS PUBLISHING, BRISTOL, GB, PAGE(S) 293-296 , XP020093590 ISSN: 1742-6596 2nd Conference on Microelectronics, Microsystems and Nanotechnology, 14-17 November 2004, Athens, Greece the whole document**
• **VOURDAS N ET AL: "Increased plasma etch resistance of thin polymeric and photoresist films" MICROELECTRONIC ENGINEERING, ELSEVIER PUBLISHERS BV., AMSTERDAM, NL, vol. 78-79, March 2005 (2005-03), pages 474-478, XP004803665 ISSN: 0167-9317**

**(Cont. next page)**

- EON D ET AL: "Resist plasma etching for 157 mn lithography" ICOPS 2002. IEEE CONFERENCE RECORD - ABSTRACTS. THE 29TH. IEEE INTERNATIONAL CONFERENCE ON PLASMA SCIENCE. BANFF, ALBERTA, CANADA, MAY 26 - 30, 2002, IEEE INTERNATIONAL CONFERENCE ON PLASMA SCIENCE, NEW YORK, NY : IEEE, US, vol. CONF. 29, 26 May 2002 (2002-05-26), pages 217-217, XP010602441 ISBN: 0-7803-7407-X
- GOGOLIDES E ET AL: "Si etching in high-density SF6 plasmas for microfabrication: surface roughness formation" MICROELECTRONIC ENGINEERING, ELSEVIER PUBLISHERS BV., AMSTERDAM, NL, vol. 73-74, June 2004 (2004-06), pages 312-318, XP004564618 ISSN: 0167-9317
- DIANA B. H. CHUA AND H. T. HG: APPLIED PHYSICS LETTERS, vol. 76, no. 6, 7 February 2000 (2000-02-07), pages 721-723, XP002396673
- YOUNGBLOOD J. AND MC CARTHY T. J.: MACROMOLECULES, vol. 32, 1999, pages 6800-6806, XP002396674 cited in the application

**Description**

**Field of the Invention**

This invention relates to a method of fabricating randomly rough columnar-like surfaces of high surface area ratio on polymer/plastic materials and to the application of such for the control of the wetting properties of such surfaces, of the liquid transport on surfaces made employing this method, and of the separation of liquids moving in microchannels the interior surfaces of which are modified according to the method described in this invention.

**Description of the related state of the art**

The wettability is an important property of a surface in practical applications, governed by both the chemical nature (surface free energy) and the geometrical structure (surface roughness) of the surface.
Two descriptions have been proposed in the art to describe the dependence of the wetting behavior of a surface on the surface roughness: the Wenzel and the Cassie-Baxter description. The Wenzel model (R.N. Wenzel, Ind. Eng. Chem. 1936, 28, p. 988) holds for cases where the liquid remains in contact with the solid surface below the liquid droplet and the enhancement in hydrophilicity or hydrophobicity by the surface roughness is quantitatively given by the following equation for the observed contact angle $\theta'_W$:

$$\cos\theta'_W = r\cos\theta \qquad\qquad (1)$$

where $\theta$ is the equilibrium contact angle on a flat surface of the same chemical character, and r is the ratio of the actual surface area to the projected area of the rough surface. The Cassie-Baxter model holds for cases where the surface topography is such that water cannot fully penetrate (for example in thin deep channels on the surface of the material) and air is trapped below the droplet which is suspended across surface protrusions. In such cases, the droplet is in contact with a composite solid and vapor surface, and thus the observed contact angle $\theta'_C$ is given by the following equation:

$$\cos\theta'_C = \Phi_s \cos\theta - (1 - \Phi_s) \qquad\qquad (2)$$

where $\varphi_s$ is the fraction of the solid surface upon which the droplet sits. Besides the difference between the predictions for the observed contact angle $\theta'_W$ and $\theta'_C$ in the two cases, one important difference between the Wenzel and the Cassie-Baxter models is that related to the ease of droplet motion on surfaces: a Wenzel surface is referred to as "sticky" and is characterized by a high contact angle hysteresis and a high tilt angle, while a Cassie-Baxter surface is referred to as "slippery" characterized by a small contact angle hysteresis and a small tilt angle (G. McHale et al., Analyst 2004, 129, p.284, and Langmuir 2004, 20, p. 10146). No matter the differences between the above mentioned descriptions, they both call for surfaces of increased surface area ratio for achieving enhancement in surface wetting properties.

In the last years, the application of super-hydrophobic surfaces as water-repellent coatings has attracted significant attention for exterior applications, since several phenomena such as snow sticking or water resistance are expected to be reduced on such surfaces. In order to avoid decrease of this property with outdoors use, coating of such surfaces with photocatalysts has been proposed for attaining degradation of pollutants on superhydrophobic surfaces, thus enhancing the self-cleaning ability of such type of surfaces (H. Yamashita, et al., Nucl. Instr. and Meth. in Phys. Res. B 206 (2003), p. 898). Besides water-repellency, another important characteristic of a superhydrophobic surface is its low hysteresis (difference between advancing and receding contact angles), which results in easing of droplet motion on such surfaces by use of low tilt angles or low driving forces (G. McHale et al., Analyst 2004, 129, p.284). Such forces can be applied by external fields such as static electric fields, which have been used to control the droplet motion on superhydrophobic surfaces (K. Takeda et al., Jpn. J. Appl. Phys. 41, 2002, p. 287).
In addition, the Cassie-Baxter state of superhydrophobic surfaces is characterized as "slippery", in the sense that a droplet does not stick but rolls on such surface. Thus, the pressure-driven flow of liquids inside microchannels with superhydrophobic interior surfaces necessitates smaller pressure difference to maintain the flow.
Surfaces of high aspect ratio have recently attracted interest for use in microfluidic devices for analytical purposes, where the chemistry of the walls becomes a significant component in the reaction. For example, microstructures of high aspect ratio have been used in microfluidic devices for liquid chromatography or capillary electrochromatography, for providing high surface to volume ratio leading to enhancement of the analytical performance of the device (N. Lion et al., Electrophoresis 2003, 24, p. 3533).
For the fabrication of surfaces of high surface area ratio (the actual surface area divided by the projected area), a lot of effort, inspired in many cases from the natural world (Lin Feng, et al., Adv. Mat. 2002, 14(24), p.1857), has focused on the development of different methodologies for designing micro- or nano-textured surfaces on a variety of materials.

Polymeric films (polyurethane, polyvinylidene fluoride) were templated on materials such as porous alumina or silica colloidal assembly, respectively, (X. Zhao and W. Li, Surface & Coatings Technology 2004, and J. Li et al., Appl. Surf Sci. 2005) in order to modulate their morphology and obtain enhanced surface roughness.

TiO2 nanoparticles mixed with fluorinated copolymers were coated on substrates by spraying (C-T. Hsieh et al., Appl. Surf Sci. 2005, 240, p. 318) to yield fluorinated surfaces of high surface roughness.

Electrochemical deposition of Gold (F. Shi, et al., Adv. Mater. 2005, 17(8), p. 1005) and Silver (N. Zhao, et al., Langmuir 2005, 21, p. 4713) aggregates followed by chemisorption of a monolayer of n-dodecanothiol has been used for creating nanostructured surfaces of super-hydrophobic character.

Electro-deposition of Copper has been also used in combination with lithography and etching to result in rough and patterned surfaces (dual scale roughness) of high surface area, which when hydrophobized gave superhydrophobic surfaces (N.J. Shirtcliffe, et al., Adv. Mater. 2004, 16(21), p. 1929, and Langmuir 2005, 21, p. 937). High-aspect-ratio-structured surfaces have been obtained by either polymer nanofibers and aligned carbon nanotubes (Lin Feng, et al., Adv. Mat. 2002, 14(24), p.1857) or by photolithography and plasma etching of Si (M. Callies, et al., Microelectronic Engineering 2005, 78-79, p. 100), to obtain superhydrophobic surfaces.

Plasma techniques have been also used to either modify the chemistry and the surface morphology of polymeric surfaces such as a) polybutadiene to render them super-hydrophobic through fluorination and surface roughening (I. Woodward, et al., Langmuir 2003, 19, p. 3432), b) Polypropelene to render the surface superhydrophobic through roughening by etching faster the crystalline versus the amorphous phase and co-sputtering of Poly(tetrafluoroethylene) (J. P. Youngblood and T. J. McCarthy Macromolecules 1999, 32, p. 6800), c) Poly(ethylene terephthalate) to render the surface superhydrophobic by etching faster the linear versus the phenolic parts of the polymer chain using mild plasma conditions and subsequent deposition of hydrophobic polymer (K. Teshima et al. Appl. Surf. Sci. 2005, 244 p. 619), or d) to deposit ribbon-like randomly-distributed microstructures used as super-hydrophobic fluorocarbon coatings (P. Favia, et al., Surface & Coatings Technology 2003, 169-170, p.609).

In addition, plasma over-etching of a photoresist layer coated on Si followed by fluorocarbon plasma deposition has been used for the fabrication of surfaces of tunable hydrophobicity depending on the density of the residual photoresist particles on the Si surface (L.-M. Lacroix et al., Surface Science 2005).

However, methods a,b,c, described above, which use some selective plasma nanotexturing, present the problem that their application is restricted to the properties of specific polymers, and that they use mild conditions, which are not suitable for fast and anisotropic etching, which is desired for the fabrication of microfluidic devices.

Further, although methods a, b, c, d described above as well as the method of L.-M. Lacroix et al., Surface Science 2005, fabricate surfaces of high surface area, they do not achieve surfaces of high aspect ratio, which would obtain robust hydrophobic substrates.

Therefore, what is missing from the state of the art is a generic fast method suitable for different polymers/plastics (such as purely organic or also inorganic containing) and suitable for different plasma gas chemistries, which permit anisotropic etching.

A common feature of all the above mentioned methodologies is that the size and density of the (random or ordered) microstructures on the surfaces can be changed controllably in a way that water contact angles can increase with roughness and a transition between Wenzel type and Cassie-Baxter type (super-hydrophobic) surfaces is observed. Usually, the Cassie-Baxter surface state is not stable, as the corresponding energy is a local but not the global minimum (N. Patankar, Langmuir 2003, 19, p. 1249), and the transition from composite (Cassie-Baxter) to wetted (Wenzel) contact is followed by a reduction in the contact angle ($\theta'_C > \theta'_W$). To obtain a robust substrate characterized by a minimal difference between $\theta'_C$ and $\theta'_W$, we need to follow specific design rules (N. Patankar, Langmuir 2003, 19, p. 1249) which dictate the use of tall slender columns as microstructures on surfaces. Such requirements (nano-collumns and contact angles) cannot be easily satisfied by the known until now standard patterning techniques (lithography and plasma etching).

The present invention provides a simple and fast process for the fabrication of random columnar-like high aspect ratio surfaces on a commercial silicone, a widespread material for the fabrication of microfluidic devices or any organic-inorganic polymer. Contrary to the above mentioned state of the art (N. Patankar, 2003) which requires that nanolithography is a necessary step for the fabrication of nanostructures, of which high aspect ratio nanolithography has high equipment and execution costs, the method provided by the present invention overcomes this step and thus, may be fulfilled in any laboratory having plasma etching equipment.

In addition it provides a simple process for the fabrication of random columnar-like high aspect ratio surfaces on a commercial Plexiglas (PMMA-poly(methylmethacrylate)) or any commercial organic polymer containing components with different plasma etching behavior, un-etchable impurities or additives, as well as on any other material containing elements with different plasma etching behavior.

The process described in the present invention may be applied for the fabrication of (a) surfaces of controlled wetting properties, (b) surfaces exhibiting low friction against droplet motion and the use of electric fields for control of droplet motion on these surfaces, (c) interior surfaces of micro-channels requiring reduced pressure for pressure-driven flow of liquids through these channels, (d) interior surfaces of micro-channels used in liquid chromatography or capillary electrochromatography or capillary electrophoresis of analytical microdevices. (e) surfaces of plastics with controlled wetting properties in combination with the desired transparency.

In practice, the method of the present invention is applied, among others, to the plastics industry, micro-analytical devices, so called "smart" and self-cleaning surfaces of any size and nature, such as for example for the formation of substrates on glasswalls (self-cleaning glasses), on anti-corrosion surfaces, on vehicles, buildings etc. for protection of any surface exposed to the air and on which it is desirable to avoid deposition of pollutant particles.

## Summary of the invention

It is an object of the present invention to provide a fast method of fabricating columnar-like high aspect ratio structures on surfaces by means of plasma etching techniques. Preferably, the surfaces on which the columnar structures are made are polymer/ plastic. The polymer contains elements in its volume and/or on its surface which have different etching behaviour (etchable versus un-etchable) in the plasma used.

This invention also provides a method for the control of the wetting properties of the above surface, using columnar-like high aspect ratio structures with a proper chemical modification in plasmas, so as to render it highly hydrophilic or super-hydrophobic.

It is yet another object of this invention to provide a simultaneous control of the wetting properties plus transparency of polymeric/plastic substrates.

It is yet another object of this invention to provide a method for controlling the transport of liquid droplets on such superhydrophobic surfaces (characterized by low friction to droplet motion) by means of electric fields or of liquids inside microchannels the interior surface of which is made super-hydrophobic according to the process described in this invention.

It is yet another object of this invention to use the highly hydrophilic surfaces fabricated according to the present invention as the interior surfaces of a micro-channel of a liquid chromatography or capillary electrochromatography or capillary electrophoresis microdevice, where said structures are used as microfabricated support structures.

## Brief description of drawings

The invention is illustrated in the following figures:

Figure 1 is an SEM image of a tilted silicone surface (PDMS) after a 6 min $SF_6$ plasma treatment (initial film thickness: 6 $\mu$m). Nano-"grass" (i.e. nano-collumns) 1.45 $\mu$m-high is shown.

Figure 2 is an AFM top view image of a silicone surface (PDMS) after 2 min treatment in $SF_6$ plasma. Roughness analysis gave an rms value of 133 nm and a periodicity of 240 nm. Initial film thickness: 20$\mu$m.

Figure 3 is an image of a water droplet- advancing 157°, receding 154°, hysteresis 3°- on a silicone surface (PDMS) after 2 min $SF_6$ plasma treatment and deposition of a 20 nm-thick fluorocarbon film. Initial PDMS film thickness: 2 $\mu$m.

Figure 4 is an image of a water droplet during its rolling off (after being thrown on the surface) on a 6 $\mu$m thick silicone (PDMS) layer after treated for 6 min in $SF_6$ plasma and deposition of a 20 nm-thick fluorocarbon film.

Figure 5 shows line scans using a stylus profilometer of the surface of Plexiglass (PMMA-poly(methylmethacrylate)) sheets after Oxygen plasma treatment at various times (10, 30, 60, 120 min), as well as Atomic Force Microscope (AFM) scans after Oxygen plasma treatment for 2 and 5min. The columnar structure can be observed

Figure 6 is an image of a water droplet - advancing 155°, receding 148°, hysteresis 7°- on a commercial Plexiglas (PMMA-poly(methylmethacrylate) surface after 30min Oxygen plasma treatment in a high density plasma reactor, and spin coating deposition of a 20nm fluorocarbon film. The droplet is actually rolling on the plexiglass surface.

Figure 7 shows the variation of the static, and advancing contact angle and hysteresis of a Plexiglass surface after Oxygen plasma treatment and spin-coating with 20nm fluorocarbon polymer, as a function of the time of plasma treatment. The surface becomes superhydrophobic after only 15min of plasma treatment. Shorter times of treatment are possible when plasma deposited fluorocarbon polymer is used.

Figure 8 shows Three-Dimensional Atomic-Force-Microscope (AFM) images of Plexiglass surfaces after Oxygen plasma treatment for 2 min (Fig. 8a) and 5 min (Fig. 8b). The surface area ratio is 1.7 for 2min and 2.4 for 5min oxygen plasma treatment. Therefore a plasma treatment only between 5 to 10min is enough to create high surface area ratio and lead to superhydrophobic surfaces after coating with plasma deposited fluorocarbon layer, which conforms better to the topography compared to the spin-coated fluorocarbon layer.

**Description of the preferred embodiments**

According to a preferred embodiment, the present invention presents a novel and easy to implement method for fabricating surfaces of high aspect ratio, based on plasma treatment of poly-dimethyl siloxane (PDMS). PDMS contains organic methyl ($-CH_3$) groups attached on an inorganic backbone ($-[Si-O]_n-$).

Advantageously, the present invention presents a novel and easy to implement technique for fabricating surfaces of high aspect ratio, based on plasma treatment of any other polymeric material containing elements of different plasma etching behavior.

Advantageously, any commercial organic polymer/plastic such as Plexiglass (PMMA-poly(methylmethacrylate)) which contains components with different plasma etching behavior, and/or small amounts (<1%) of metallic elements (such as Al, Fe) as contaminants from the fabrication process of the polymer/plastic may be used for the realization of the invention.

Advantageously, any commercial organic polymer /plastic such as Plexiglass (PMMA-poly(methylmethacrylate)) which may have in addition to volume contaminants also surface contaminants (such as metallic or semiconducting elements or other material with different etching behaviour compared to that of the polymer) due to a previous sputtering or other nanometer thick coating process, may be used for the realization of the invention.

As a result, organic groups are expected to etch much faster compared to their inorganic etch resistant counterparts, which contribute to the formation of non-volatile products on etched surfaces and thus behave as masking materials to etching.

Preferred embodiments of the invention are presented in the following examples:

Example 1:

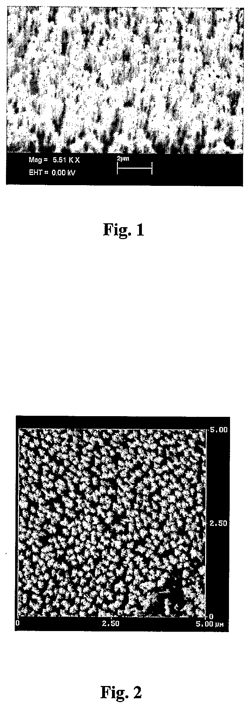

As basic material, a commercial siloxane (Silguard 184 supplied by Dow Corning), thermally curable, is used. This is an innate hydrophobic material, widely used in the fabrication of microfluidic devices, giving a water contact angle of 105°. We prepare siloxane films by spin coating of the polymer and curing agent mixture on a substrate surface and subsequent thermal curing to result in $2\mu m$-2mm -thick films. These films are then exposed to $SF_6$ plasma treatment, in an inductively coupled plasma (ICP) reactor, under conditions ensuring high etch rates (pressure of 10 mTorr, plasma power 1900 W, and bias voltage -100 V). For plasma exposures in the range 2-16 min, we observed formation of columnar-like structures or micro- and nano-"grass" with height ranging from a few 100's nm to 6 $\mu m$, depending on the treatment time. Figure 1 shows an SEM image of a PDMS surface after a 6 min treatment in $SF_6$ plasma. This image reveals densely packed nanocollumns on the surface of PDMS of average height of 1.45 $\mu m$ and of diameter of the order of 100 nm. This dense distribution of nanocollumns on the PDMS surface is further verified by AFM imaging, as shown in Fig. 2. An average collumn diameter of 130 nm is indicated and a surface fraction of about 25% can be calculated as covered by the collumn tops.

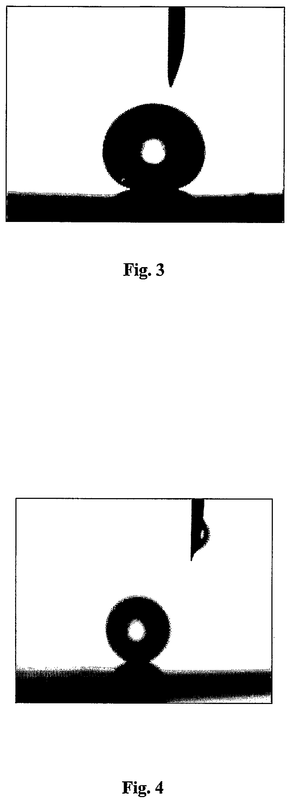

After exposure to $SF_6$ plasma, a depositing $C_4F_8$ plasma is used in the same reactor (ICP), under plasma conditions ensuring conformal deposition of a thin (20-nm-thick) fluorocarbon film (FC) on the formed columnar structures (Pressure 40 mTorr, plasma power 800 W, bias voltage -100 V). The combination of the FC hydrophobicity with the surface nano-texturing results in the enhancement of the contact angle of water droplets on the surface to more than 150° (Fig. 3), even after a short treatment in $SF_6$ plasma (2 min). The dense "forest" of nano-collumns shown in the AFM image (Fig. 2) cannot allow the water to penetrate and wet the surface of the collumns, thus water droplets are sitting on a composite solid and air surface, leading to low values of contact angle hysteresis (average of 3°). The low hysteresis is further evidenced by the rolling of water droplets when thrown on the surface (Fig. 4) and the inability to detach a droplet from the needle using contact with the surface. All these observations provide evidence that water droplets on these surfaces behave according to the Cassie-Baxter model. In fact, the enhancement of the surface hydrophobicity from 118° (contact angle on a flat FC surface) to 147° (contact angle on a nano-textured surface) as given by the Cassie-Baxter Equation (2) indicates a water droplet in contact with the nano-collumn tops covering a surface fraction $\varphi_s$ equal to 30%, in good agreement with the estimation of the surface fraction covered by the collumn top surface based on the AFM image in Fig. 2.

Example 2:

In another preferred embodiment of the present invention, siloxane surfaces treated as described above (first in $SF_6$ and then in $C_4F_8$ plasmas) are used as surfaces of minimal friction to water droplet motion. This is due to the small contact area of the droplets with the surface and the low contact angle hysteresis, as it was described in the previous paragraph. Therefore, the motion of droplets on such surfaces can be controlled by external forces such as the electrostatic force exerted on a droplet resting on a siloxane plasma-treated surface by means of a voltage applied on an electrode located to a small distance from the droplet. Experiments performed by the inventors have shown that relatively small voltages (below 100 V) applied by a metallic pin located a few hundred microns away from the droplet are sufficient to cause droplet motion.

Example 3:

In another preferred embodiment of the present invention, the method described above for fabrication of superhydrophobic surfaces is used to modify the interior surface of microchannels fabricated in PDMS or in other polymeric material through soft lithography or other patterning technique (for example, photolithography). If the flow inside the microchannels is pressure-driven, a small pressure difference would suffice to maintain the flow inside the microchannels, due to the non-sticky but slippery nature of the superhydrophobic interior surfaces of the microchannels.

Example 4:

In another preferred embodiment of the present invention, the method described above is used for the fabrication of columnar-like nanostructures inside the microchannels of an analytical microdevice (such as those used for liquid chromatography, or capillary electrochromatography or capillary electrophoresis or other relevant analytical technique). Preferably, the height of the nano-columns is comparable to the height of the microchannel, and the density of the fabricated nanostructures can be adjusted according to the surface-to-volume requirements of the device for enhanced analytical performance (high resolution, short analysis time). In addition the high surface area of the very rough micro-channels can be used for adjustment of the zeta potential (surface charge) and the electroosmotic flow.

Example 5:

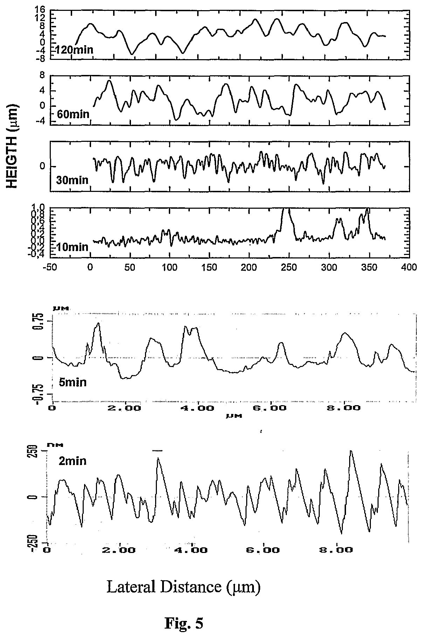

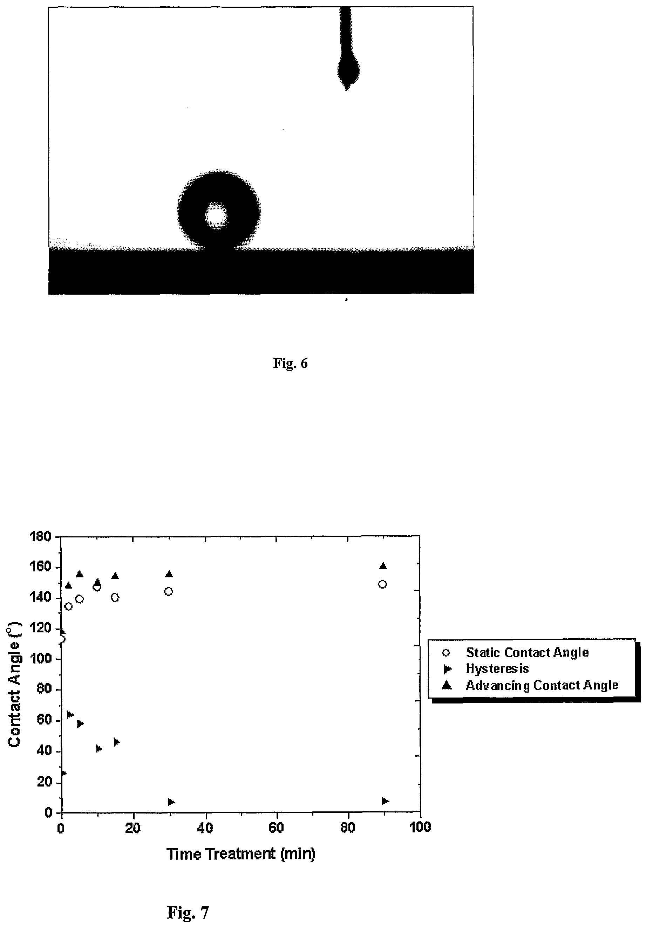

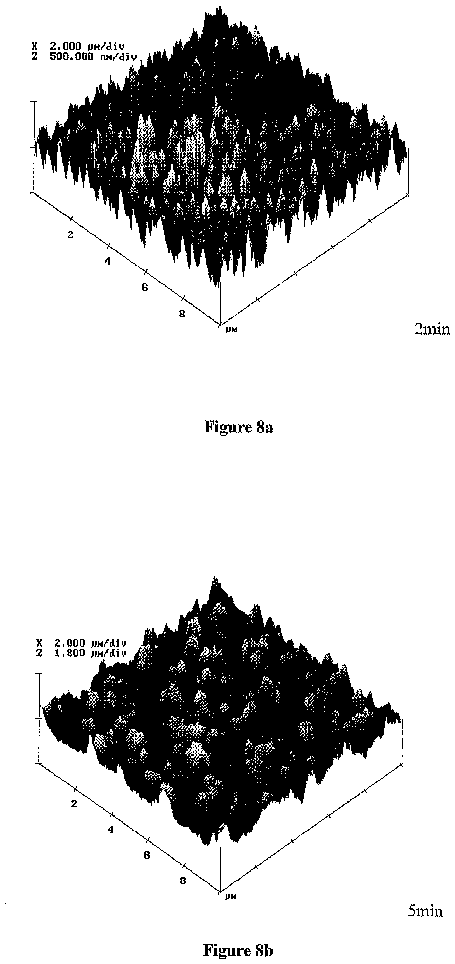

Organic polymer sheets of Plexiglass (PMMA-poly(methylmethacrylate) are treated in an oxygen plasma. The commercially available polymer in thicknesses from 1 to several mm, includes less than 1% metallic impurities which do not etch in the oxygen plasma, as we verified by EDAX analysis of the sheets. Plexiglass has a smooth surface, is transparent to visible light, and has a contact angle of 60°, and is a material widely used in microfluidic devices. These sheets are then exposed to $O_2$ plasma treatment, in an inductively coupled plasma (ICP) reactor, under conditions ensuring high etch rates (pressure of 5 mTorr, plasma power 1900 W, and bias voltage -100 V). For plasma exposures in the range 2-90 min, we observed formation of columnar-like structures or micro- and nano-"grass" with height ranging from a few 100's nm to 8 $\mu$m, depending on the treatment time. Figure 5 shows line scans using a profilometer or an Atomic Force Microscope (AFM) of a plexiglass surface after treatment in Oxygen plasma for several instances. This image reveals nanocolumns on the surface of plexiglass of peak to peak height ranging from 0.25 to 8 $\mu$m depending on the plasma treatment time.
After oxygen plasma treatment a fluorocarbon layer is deposited on the surface of the Plexiglass by spin coating or by a depositing plasma as was described above for PDMS surfaces. The combination of the FC hydrophobicity with the surface nano-texturing results in the enhancement of the contact angle of water droplets on the surface to more than 150° (Fig. 6), after a 15min treatment in Oxygen plasma. The dense "forest" of nano-collumns shown in the profilometer or AFM scans (Fig. 5) as well as the AFM images of Figures 8a and 8b cannot allow the water to penetrate and wet the surface of the collumns, thus water droplets are sitting on a composite solid and air surface, leading to low values of contact angle hysteresis (average of 7°). The low hysteresis is further evidenced by the rolling of water droplets when thrown on the surface (Fig. 6) and the inability to detach a droplet from the needle using contact with the surface. All these observations provide evidence that water droplets on these surfaces behave according to the Cassie-Baxter model.
When studying the variation of the water contact angle and contact angle hysteresis versus the time of oxygen plasma treatment and after spin coating with 20nm Teflon-like polymer (Figure 7) we observe that the surface of plexiglass quickly becomes very hydrophobic, but with large hysteresis. At very small treatment times the surface is hydrophobic and "sticky" (i.e. has a large hysteresis), revealing a surface of the Wenzel type, while at medium treatment times longer than 15min the surface becomes superhydrophobic with minimal hysteresis and is non "sticky", thus following the Cassie-Baxter model. These treatment times refer to spin coated fluorocarbon films, while shorter times are obtained with plasma deposited fluorocarbon films, when the surface becomes superhydrophobic after approximately 5-10min of oxygen plasma treatment and plasma fluorocarbon deposition. Indeed the AFM images of Figures 8a and 8b show that the surface area ratio is 1.7 for 2min treatment, while it raises to 2.4 for 5min treatment. The superhydrophobic plexiglass or other oxygen plasma treated organic polymer may however be milky (less transparent) after the plasma treatment.

Example 6:

In another preferred embodiment of the present invention the surface roughness and wettability can be adjusted without sacrificing the transparency of the plastic and in fact tuning the minimum cutoff wavelength of light transmission through the plastic. This can be accomplished by increasing the amount of unetchable metallic or other elements that exist as contaminants in the plastic and or changing the plasma etching conditions, such as the bias voltage. In this example we sputtered on the surface of plexiglass platinum (or other metal) monolayers or alternatively we created residues and "dirt" using an inorganic polymer or photoresist. The purpose was to increase the amount of unetchable contaminants on the surface of the plastic. The surface roughness increased after oxygen plasma treatment and the surfaces become superhydrophobic after Teflon coating before losing their transparency.

Example 7:

In another preferred embodiment of the present invention, Plexiglass surfaces treated as described above (first in oxygen and then in $C_4F_8$ plasmas) are used as surfaces of minimal friction to water droplet motion. This is due to the small contact area of the droplets with the surface and the low contact angle hysteresis, as it was described in the previous paragraph.

Example 8:

In another preferred embodiment of the present invention, the method described above for the fabrication of superhydrophobic surfaces is used to modify the interior surface of microchannels fabricated in Plexiglass. If the flow inside the microchannels is pressure-driven, a small pressure difference would suffice to maintain the flow inside the microchannels, due to the non-sticky but slippery nature of the superhydrophobic interior surfaces of the microchannels.

Example 9:

It is another preferred embodiment of the present invention, the method described above was used for the fabrication of columnar-like nanostructures inside the microchannels of an analytical microdevice (such as those used for liquid chromatography, or capillary electrochromatography or capillary electrophoresis or other relevant analytical technique). The height of the nano-columns may be comparable to the height of the microchannel, and the density of the fabricated nanostructures can be adjusted according to the surface-to-volume requirements of the device for enhanced analytical performance (high resolution, short analysis time). In addition the high surface area of the very rough microchannels can be used for adjustment of the zeta potential (surface charge) and the electroosmotic flow.

**Claims**

1. A method for the fabrication of surfaces with columnar-like random roughness with height ranging from a few 100s nm to 8 $\mu$m and controlled wetting properties on organic polymers that comprise two or more components which differ with respect to their etching behaviour, one component being etch resistant, while such etch behaviour difference may preexist in the polymer by being an additive or impurity in the polymer, and / or be created on its surface from the plasma by sputtering unetchable components,
   the method comprising the following steps

   (A) exposure of said organic polymer to an oxygen containing plasma under conditions of anisotropic etching, with pressure less than 5mTorr and bias voltage below 100V
   (B) after the plasma treatment the surface becomes hydrophilic,
   (C) after coating of the surface with a fluorocarbon material the surface becomes hydrophobic or superhydrophobic, wherein the extent of hydrophobicity depends on the plasma etching time, while for superhydrophobicity the contact angle is increased above 147 degrees and the contact angle hysteresis for water droplets is reduced below 10 degrees,

   wherein the organic polymer is polymethylmethacrylate (PMMA) polymer.

2. A method for the fabrication of surfaces with columnar-like random roughness with height ranging from a few 100s nm to 6 $\mu$m and controlled wetting properties on organic polymers that contain Silicon, the method comprising the following steps:

   (A) exposure of said organic polymer to a fluorine containing plasma under conditions of anisotropic etching, with pressure less than 5mTorr and bias voltage below 100V,
   (B) after coating of the surface with a fluorocarbon material the surface becomes hydrophobic or superhydrophobic, the extent of hydrophobicity depending on the plasma etching time, while for superhydrophobicity the contact angle is increased above 147 degrees and the contact angle hysteresis for water droplets is reduced below 10 degrees,

   wherein the organic polymer that contains Silicon is polydimethylsiloxane (PDMS) polymer and in step (A) the fluorine containing plasma is a Sulfur hexafluoride.

3. The method of Claims 1 and 2 wherein the step of fluorocarbon coating comprises exposing the surface to a $C_4F_8$ plasma.

4. The method of Claims 1 and 2 wherein the step of fluorocarbon coating comprises spin coating of a fluorocarbon layer.

5. The method of any one of Claims 1 to 4, used for the fabrication of surfaces exhibiting very low friction against droplet motion, which surfaces are used for the control of the transport of droplets using electric fields.

6. The method of any one of Claims 1 to 4 used for the fabrication of surfaces serving as interior surfaces of microchannels of microfluidic devices, which surfaces exhibit reduced friction against fluid flow.

7. The method of any one of Claims 1 to 6, used for the fabrication of surfaces serving as interior surfaces of microchannels of microfluidic devices, which surfaces have desired wetting properties.

8. The method of Claim 7 comprising capillary filling and hydrophobic valving.

9. The method of any one of claims 1 to 8, used for the fabrication of surfaces serving as interior surfaces of microchannels for liquid chromatography or electrochromatography or capillary electrophoresis microdevices for separation purposes.

10. The method of any one of Claims 1 to 4 further comprising increasing the amount of unetchable metallic or other elements that exist as contaminants in the plastic and or changing the plasma etching conditions, such as the bias voltage
    by sputtering on the surface of plexiglass platinum (or other metal) monolayers or alternatively by creating residues and "dirt" using an inorganic polymer or photoresis,
    so as to controll the height and aspect ratio of the random columnar structures,
    which results in the preservation of the optical transparency and tuning of the cutoff wavelength, while still allowing control of the wetting properties from hydrophilic to hydrophobic.

**Patentansprüche**

1. Eine Methode zur Herstellung von Oberflächen mit säulenartige planlose Rauheit mit eine Höhe im Bereich von einigen Hunderte nm bis zu 8 $\mu$m und geregelte Benetzungseigenschaften in organischen Polymeren, die zwei oder mehr Komponenten beinhaltet, die sich in Bezug auf ihr Ätzverhalten unterscheiden wobei eine Komponente ätzresistent ist, welcher Ätzverhaltensunterschied in dem Polymer vorhanden sein kann, indem ein Zusatzstoff oder eine Verunreinigung in dem Polymer enthalten ist und/oder auf seine Oberfläche aus dem Plasma durch Sputtern nicht entfernbare Komponenten erzeugt werden können, wo die Methode die folgenden Schritte enthält

   (A) Exposition des organischen Polymers in einem sauerstoffhaltigen Plasma unter anisotropen Ätzbedingungen mit einem Druck von weniger als 5 mTorr und einer Vorspannung von weniger als 100 V
   (B) nach der Plasmabehandlung die Oberfläche wird hydrophil
   (C) nach eine Beschichtung der Oberfläche mit einem Fluorkohlenstoffmaterial wird die Oberfläche hydrophob oder superhydrophob, worin das Ausmaß der Hydrophobie von der Plasmaätzzeit abhängt, wobei in Bezug auf die Superhydrophobie der Kontaktwinkel über 147 Grad erhöht wird und die Kontaktwinkelhysterese für Wasser Tröpfchen unter 10 Grad reduziert ist, wobei das organische Polymer Polymethylmethacrylat (PMMA) -Polymer ist.

2. Eine Methode zur Herstellung von Oberflächen mit säulenartige planlose Rauheit mit eine Höhe im Bereich von einigen Hunderte nm bis zu 6 $\mu$m und geregelte Benetzungeigenschaften in organischen Polymeren, die Silizium enthalten, wo die Methode die folgenden Schritte enthält:

(A) Exposition des organischen Polymers in einem fluorhaltigen Plasma unter anisotropen Ätzbedingungen mit einem Druck von weniger als 5 mTorr und einer Vorspannung von weniger als 100 V,
(B) Nach Beschichtung der Oberfläche mit einem Fluorkohlenstoffmaterial wird die Oberfläche hydrophob oder superhydrophob, worin das Ausmaß der Hydrophobie von der Plasmaätzzeit abhängt, wobei in Bezug auf die Superhydrophobie der Kontaktwinkel über 147 Grad erhöht wird und die Kontaktwinkelhysterese für Wasser Tröpfchen unter 10 Grad reduziert ist, wobei das Silizium enthaltendes organisches Polymer, Polydimethylsiloxan ist (PDMS) -Polymer und in Schritt (A) das fluorhaltigen Plasma ein Schwefelhexafluorid ist.

3. Die Methode nach Ansprueche 1 und 2, wobei der Schritt der Fluorkohlenstoffbeschichtung die Exposition der Oberfläche in ein $C_4F_8$ -Plasma beinhält.

4. Die Methode nach Ansprueche 1 und 2, wobei der Schritt der Fluorkohlenstoffbeschichtung die Spin-beschichtung einer Fluorkohlenstoffschicht beinhält.

5. Die Methode nach einem der Ansprüche 1 bis 4, die zur Herstellung von Oberflächen, die eine sehr geringe Reibung gegenüber einer Tröpfchen-Bewegung ausstellen, verwendet wird, welche Oberflächen zur Steuerung des Tröpfchen-transports unter Verwendung von elektrischen Feldern verwendet werden.

6. Die Methode nach einem der Ansprüche 1 bis 4, die zur Herstellung von Oberflächen, die als innere Oberflächen von Mikrokanälen von mikro-fluidischen Geräte benutzt werden, verwendet wird, welche Oberflächen eine verminderte Reibung gegen den Flüssigkeitsströmung zeigen.

7. Die Methode nach einem der Ansprüche 1 bis 6, die zur Herstellung von Oberflächen, verwendet wird, die als innere Oberflächen von Mikrokanälen von mikro-fluidischen Vorrichtungen benutzt werden, welche Oberflächen erwünschte Benetzungseigenschaften besitzen.

8. Die Methode nach Anspruch 7, die kapillare Füllung und hydrophobe Ventile beinhält.

9. Die Methode nach einem der Ansprüche 1 bis 8, die zur Herstellung von Oberflächen verwendet wird, die als innere Oberflächen von Mikrokanälen von mikro-fluidischen Geräte benutzt werden, die für Flüssigchromatographie- oder Elektrochromatographie- oder Kapillarelektrophorese- von mikro-fluidischen Geräte für Trennzwecke benutzt werden.

10. Die Methode die nach einem der Ansprüche 1 bis 4 zusätzlich beinhaltend das Erhöhen der Menge an nicht entfernbaren metallischen oder anderen Elementen, die als Verunreinigungen in dem Polymer existieren, und/oder durch die Änderung der Plasmaätzbedingungen so wie die Vorspannung,
durch Sputtern auf die Oberfläche des Plexiglases mit Platin (oder anderen Metall) Monoschichten oder alternativ durch die Erzeugung von Residuum und "Schmutz" mit die Benutzung eines anorganischen Polymers oder Fotolackes,
um die Höhe und das Seitenverhältnis der planlose Säulenstrukturen zu kontrollieren,
was zur Erhaltung der optischen Transparenz und Einstellung der Grenzwellenlänge führt, während die Benetzungseigenschaften immer noch von hydrophil zu hydrophob kontrolliert werden können.

**Revendications**

1. Méthode pour la fabrication de surfaces avec une rugosité aléatoire de type colonnaire avec une hauteur allant de quelques 100 nm à 8 $\mu$m et propriétés mouillantes contrôlées sur les polymères organiques qui comprennent deux ou plusieurs composants qui diffèrent par rapport à leur comportement de gravure, un composant étant résistant à la gravure, alors qu'une telle différence de comportement peut préexister dans le polymère en étant un additif ou une impureté dans le polymère, et / ou etre créé à sa surface à partir du plasma en pulvérisant des composants intangibles, la methode comprenant les étapes suivantes

(A) exposition dudit polymère organique à un plasma contenant de l'oxygène dans des conditions de gravure anisotrope, avec une pression inférieure à 5mTorr et une tension de polarisation inférieure à 100V

(B) après le traitement par plasma, la surface devient hydrophile,

(C) après revêtement de la surface avec un matériau fluorocarboné, la surface devient hydrophobe ou super-rhydrophobe, où l'étendue de l'hydrophobicité dépend du temps de gravure du plasma, tandis que pour la superhydrophobie, l'angle de contact est augmenté au-dessus de 147 degrés et l'hystérésis de l'angle de contact pour les gouttelettes d'eau est réduit en dessous de 10 degrés,

ou le polymère organique est un polymère de polyméthylméthacrylate (PMMA).

**2.** Une méthode pour la fabrication de surfaces avec une rugosité aléatoire de type colonnaire avec une hauteur allant de quelques 100s nm à 6 $\mu$m et propriétés de mouillant contrôlées sur des polymères organiques contenant du silicium, la methode comprenant les pas suivants:

(A) exposition dudit polymère organique à un plasma contenant du fluor dans des conditions de gravure anisotrope, avec une pression inférieure à 5mTorr et une tension de polarisation au dessous de 100V,

(B) après revêtement de la surface avec un matériau fluorocarboné, la surface devient hydrophobe ou super-rhydrophobe, l'étendue de l'hydrophobicité dépend du temps de gravure du plasma, tandis que pour la super-rhydrophobie, l'angle de contact est augmenté au-dessus de 147 degrés et l'hystérésis de l'angle de contact pour les gouttelettes d'eau est réduite au-dessous de 10 degrés,

ou le polymère organique qui contient du silicium est le polydimethylsiloxane (PDMS) et à l'étape (A) le plasma contenant du fluor est un hexafluorure de soufre.

**3.** La méthode des Revendications 1 et 2, dans laquelle l'étape de revêtement de fluorocarbone comprend l'exposition de la surface à un plasma $C_4F_8$.

**4.** La méthode des Revendications 1 et 2 dans lequel l'étape de revêtement au fluorocarbone comprend un revêtement par centrifugation d'une couche de fluorocarbone.

**5.** La méthode de l'une quelconque des Revendications 1 à 4, utilisée pour la fabrication de surfaces présentant un très faible frottement contre le mouvement des gouttelettes, surfaces lesquelles sont utilisées pour le contrôle du transport des gouttelettes à l'aide de champs électriques.

**6.** La méthode de l'une quelconque des Revendications 1 à 4, utilisée pour la fabrication de surfaces servant comme surfaces intérieures de micro-canaux de dispositifs micro-fluidiques, lesquelles surfaces présentent une friction réduite contre l'écoulement de fluide.

**7.** La méthode de l'une quelconque des Revendications 1 à 6, utilisée pour la fabrication de surfaces servant de surfaces intérieures de micro-canaux de dispositifs microfluidiques, lesquelles surfaces ont les propriétés de mouillant souhaitées.

**8.** La méthode de la Revendication 7 comprenant le remplissage capillaire et vannes hydrophobes.

**9.** La méthode de l'une quelconque des Revendications 1 à 8, utilisée pour la fabrication de surfaces servant de surfaces intérieures de micro-canaux pour la chromatographie liquide ou l'électrochromatographie ou les micro-appareils d'électrophorèse capillaire pour les buts de séparation.

**10.** La méthode de l'une quelconque des Revendications 1 à 4, comprenant en plus augmenter la quantité d'éléments non-gravables métalliques ou d'autres éléments qui existent en tant que contaminants dans le plastique et / ou modifier les conditions de gravure du plasma, telles que la tension de polarisation par pulvérisation sur la surface de plexiglass platine (ou autre métal) de monocouches ou alternativement en créant des résidus et de la "saleté" en utilisant un polymère inorganique ou une résine photosensible, à fin de contrôler la hauteur et le ratio d'aspect des structures colonnaires aléatoires, ce qui se resulte à la préservation de la transparence optique et le réglage de la longueur d'onde de coupure, tout en permettant encore le contrôle des propriétés de mouillantes de hydrophile à hydrophobe.

**Fig. 1**

**Fig. 2**

EP 1 937 757 B1

Fig. 3

Fig. 4

Lateral Distance (μm)

**Fig. 5**

Fig. 6

Fig. 7

X 2.000 µm/div
Z 500.000 nm/div

2

4

6

8

µm

2min

**Figure 8a**

X 2.000 µm/div
Z 1.800 µm/div

2

4

6

8

µm

5min

**Figure 8b**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **R.N. WENZEL.** *Ind. Eng. Chem.,* 1936, vol. 28, 988
- **G. MCHALE et al.** *Analyst,* 2004, vol. 129, 284
- *Langmuir,* 2004, vol. 20, 10146
- **H. YAMASHITA et al.** *Nucl. Instr. and Meth. in Phys. Res. B,* 2003, vol. 206, 898
- **K. TAKEDA et al.** *Jpn. J. Appl. Phys.,* 2002, vol. 41, 287
- **N. LION et al.** *Electrophoresis,* 2003, vol. 24, 3533
- **LIN FENG et al.** *Adv. Mat.,* 2002, vol. 14 (24), 1857
- **X. ZHAO ; W. LI.** *Surface & Coatings Technology,* 2004
- **J. LI et al.** *Appl. Surf Sci.,* 2005
- **C-T. HSIEH et al.** *Appl. Surf Sci.,* 2005, vol. 240, 318
- **F. SHI et al.** *Adv. Mater.,* 2005, vol. 17 (8), 1005
- **N. ZHAO et al.** *Langmuir,* 2005, vol. 21, 4713
- **N.J. SHIRTCLIFFE et al.** *Adv. Mater.,* 2004, vol. 16 (21), 1929
- *Langmuir,* 2005, vol. 21, 937
- **M. CALLIES et al.** *Microelectronic Engineering,* 2005, vol. 78-79, 100
- **I. WOODWARD et al.** *Langmuir,* 2003, vol. 19, 3432
- **J. P. YOUNGBLOOD ; T. J. MCCARTHY.** *Macromolecules,* 1999, vol. 32, 6800
- **K. TESHIMA et al.** *Appl. Surf. Sci.,* 2005, vol. 244, 619
- **P. FAVIA et al.** *Surface & Coatings Technology,* 2003, vol. 169-170, 609
- **L.-M. LACROIX et al.** *Surface Science,* 2005
- **N. PATANKAR.** *Langmuir,* 2003, vol. 19, 1249